# EUROPEAN PATENT APPLICATION

(11) **EP 4 611 182 A1**
(43) Date of publication of application: **03.09.2025**
(21) Application number: 23919927.6
(22) Date of filing: 07.12.2023
(51) Int. Cl.: H01R 13/52, H05K 5/02

(54) **DEVICE UNIT**

(30) Priority: 01.02.2023 JP 2023014027
(71) Applicant: Japan Aviation Electronics Industry, Limited, Tokyo 150-0043 (JP)
(72) Inventor: NAKAMURA, Kazunobu, Tokyo 150-0043 (JP); LI, Teng, Tokyo 150-0043 (JP); IWAO, Naoki, Tokyo 150-0043 (JP)
(74) Representative: MERH-IP Matias Erny Reichl Hoffmann Patentanwälte PartG mbB
(86) International application number: PCT/JP2023/043779
(87) International publication number: WO 2024/161792

(57) **Abstract**

Water guided to a water discharge hole from inside equipment is discharged proactively without increasing a risk of foreign matter contamination in the equipment. An equipment unit 100 comprises a case 70, an inside of which is divided into a waterproof region and a non-waterproof region, and a metal component 40 mounted in the non-waterproof region of the case. The case 70 includes a water discharge hole 76₁ provided on a side of the non-waterproof region and having a hole shape 76a penetrating from an inner side (a face 72A) to an outer side (a face 72B) of the case for discharging received water in the metal component 40, and a cut-out part 761 formed by cutting out a predetermined range on a circumference of the hole shape 76a from a position along a penetrating direction to reach the outer side (the face 72B) of the case in the water discharge hole 76₁.

## Description

### [TECHNICAL FIELD]

The present invention relates to a water discharge structure of an equipment unit.

### [BACKGROUND ART]

Some of prior art equipment units having a water discharge structure are capable of discharging entered water to the outside even if water enters the equipment (see Patent Literature 1, for example). FIGs. 1 and 2 are views showing the water discharge structure of the prior art. A vehicle-side connector 10 disclosed in this prior art includes a front housing (an inlet housing 20) which has a connector fitting part 22 of a hood shape that opens forward and which is provided with a water discharge pore 25 penetrating a lower end part of a back wall 23 of the connector fitting part 22, and includes a rear housing (a retainer 90) which has a drain part 97 capable of discharging water entered into the connector fitting part 22 to the outside of a vehicle and which is attached to a rear side of the front housing. The rear housing includes an inclined wall 95 located between the water discharge pore 25 and the drain part 97 and directed downward toward the inner side of the vehicle, and a lower surface 95A of the inclined wall 95 is located to face the water discharge pore 25.

### [PRIOR ART LITERATURE]

### [PATENT LITERATURE]

Patent Literature 1: Japanese Patent Application Laid-Open No. 2017-208227

### [SUMMARY OF THE INVENTION]

### [PROBLEMS TO BE SOLVED BY THE INVENTION]

However, depending on a size and an arranged position of a water discharge pore (hereinafter also referred to as a "water discharge hole"), water that should be discharged may stick (be trapped) to the neighborhood of a water discharge outlet of the water discharge hole. A phenomenon (hereinafter also referred to as a "trapping phenomenon") in which discharged water is trapped prevents water discharge through the water discharge hole, resulting in retention of water inside the case. This leads to a risk of corrosion of a metal component (hereinafter also referred to as a "metal component") such as a connector.

Here, forming a larger water discharge hole for avoiding the trapping phenomenon, if possible, may possibly prevent sticking of water droplets. However, forming a larger water discharge hole raises a problem of causing a risk that foreign matter contamination in equipment is likely to occur.

In view of the above-described problems, an object of the present invention is to provide an equipment unit that can proactively discharge water guided from the inside of equipment to a water discharge hole without increasing the risk of foreign matter contamination in the equipment.

### [MEANS TO SOLVE THE PROBLEMS]

In order to solve the above-described problems, an equipment unit according to the present embodiment comprises a case, an inside of which is divided into a waterproof region and a non-waterproof region, and a metal component mounted in the non-waterproof region of the case. The case includes a water discharge hole provided on a side of the non-waterproof region and having a first hole shape penetrating from an inner side to an outer side of the case for discharging received water in the metal component, and a cut-out part formed by cutting out a predetermined range on a circumference of the first hole shape from a position along a penetrating direction to reach the outer side of the case in the water discharge hole.

### [EFFECTS OF THE INVENTION]

The equipment unit of the present embodiment includes the cut-out part formed by cutting out the predetermined range on the circumference of the first hole shape from a position along the penetrating direction to reach the outer side of the case in the water discharge hole. By providing this cut-out part, a liquid droplet resulting from retained received water can be made larger in diameter and easier to drop than in a case in which the cut-out part is not provided. Thus, water entered into the water discharge hole in equipment can be discharged proactively without increasing the risk of foreign matter contamination in the equipment.

### [BRIEF DESCRIPTION OF THE DRAWINGS]

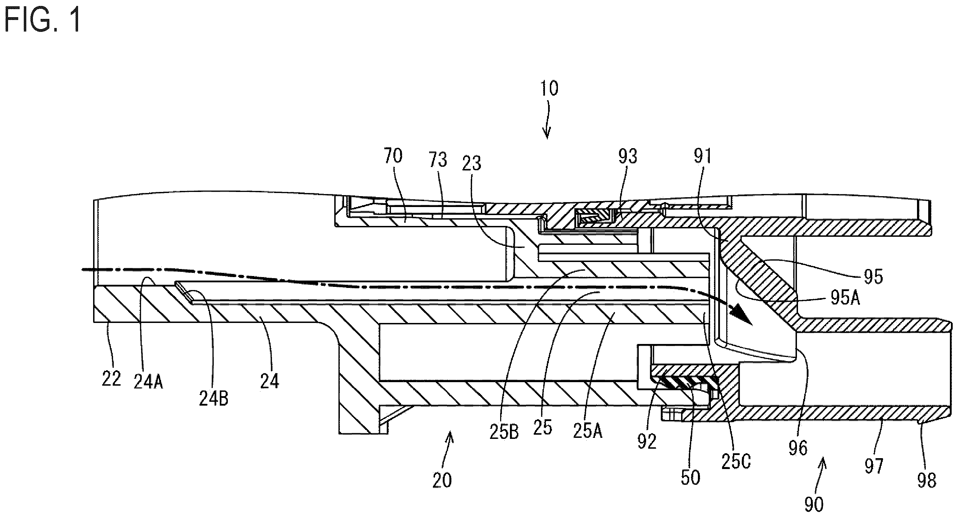

**[****FIG.1]** FIG. 1 is a view for describing a prior art of an equipment unit having a water discharge structure.
**[****FIG.2]** FIG. 2 is a view for describing the prior art of the equipment unit having the water discharge structure.
**[****FIG.3]** FIG. 3(a) is a perspective view showing an embodiment of a connector unit as an example of an equipment unit in the present embodiment, FIG. 3(b) is a side view thereof, and FIG. 3(c) is a front view thereof.
**[****FIG.4]** FIG. 4(a) is a rear view of the connector unit shown in FIG. 3(a), and FIG. 4(b) is a cross-sectional view taken along the line C-C in FIG. 4(a).
**[****FIG.5]** FIG. 5 is an exploded perspective view of the connector unit shown in FIG. 3(a).
**[****FIG.6]** FIG. 6(a) is a perspective view showing a printed circuit board 35 in the connector unit shown in FIG. 3(a), and FIG. 6(b) is a side view of a printed wiring board 30 shown in FIG. 6(a).
**[****FIG.7]** FIG. 7(a) is a perspective view of the printed circuit board 35 with which a waterproof sealing member 60 has been formed integrally, and FIG. 7(b) is a cross-sectional view of a connector unit 100 as seen from a side of an interface connector 40 in a case of being cut along a plane including a boundary 30c.
**[****FIG.8]** FIG. 8(a) is a rear view showing an embodiment of the connector unit in a case of having a back face cover 80, and FIG. 8(b) is a cross-sectional view taken along the line C-C in FIG. 8(a).
**[****FIG.9]** FIG. 9 is a view for describing a water-guiding member 28, in which FIG. 9(a) is a view displaying a region from a front face plate part 74 in FIG. 3(b) to a line B-B in the cross-sectional view taken along the line A-A in FIG. 3(c), FIG. 9(b) is a cross-sectional view taken along the line B-B in FIG. 3(b), FIG. 9(c) is a perspective view of FIG. 9(b) as seen from a left upper direction, and FIG. 9(d) is a perspective view of FIG. 9(b) as seen from a left lower direction.
**[****FIG.10]** FIG. 10 is an enlarged view in a region indicated by a dash-dotted line in FIG. 9(a).

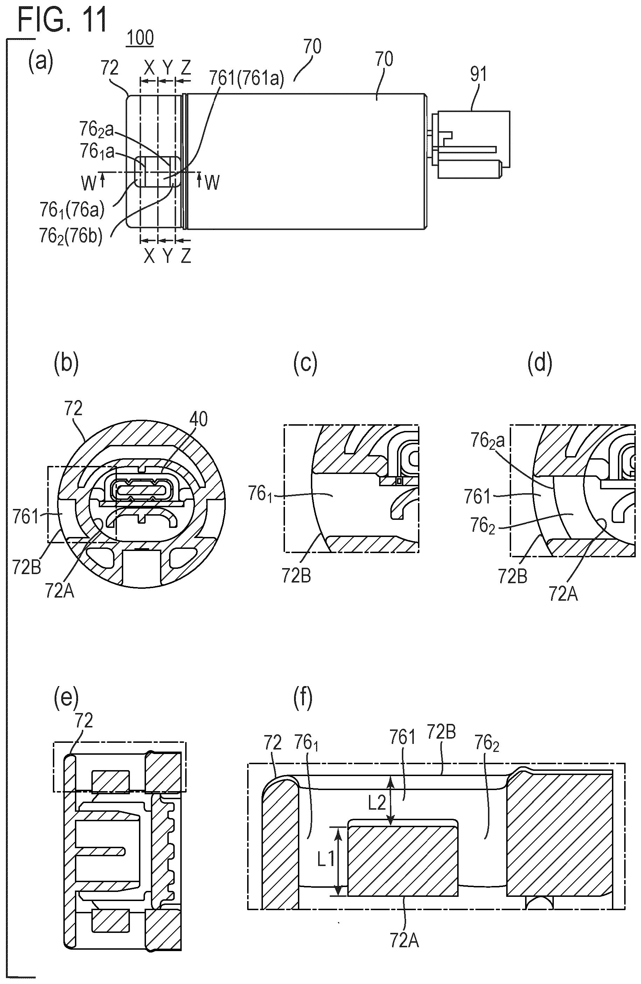

**[****FIG.11]** FIG. 11 is a view for describing water discharge holes 76₁, 76₂ and a cut-out part 761 according to a first embodiment, in which FIG. 11(a) is a side view of the connector unit 100, FIG. 11(b) is a cross-sectional view taken along the line Y-Y in FIG. 11(a), FIG. 11(c) is an enlarged view corresponding to a region enclosed by a dash-dotted line in FIG. 11(b) in a cross-sectional view taken along the line X-X in FIG. 11(a), FIG. 11(d) is an enlarged view corresponding to a region enclosed by a dash-dotted line portion in FIG. 11(b) in a cross-sectional view taken along the line Z-Z in FIG. 11(a), FIG. 11(e) is a cross-sectional view taken along the line W-W in FIG. 11(a), and FIG. 11(f) is an enlarged view of a region indicated by a dash-dotted line in FIG. 11(e).
**[****FIG.12]** FIG. 12 is a schematic view corresponding to FIG. 11(f) showing an example of an influence on water discharge caused by providing the cut-out part 761, in which FIG. 12(a) is a case in which the cut-out part 761 is not provided, and FIG. 12(b) is a case in which the cut-out part 761 is provided.
**[****FIG.13]** FIG. 13 is a view for describing water discharge holes and a cut-out part according to a modification of the first embodiment, in which FIG. 13(a) is a schematic view presenting the vicinity of a water discharge hole 76₁ and a water discharge hole 76₂ in FIG. 11(a) in a simplified manner, and FIG. 13(b) to FIG. 13(f) are schematic views presenting water discharge holes and a cut-out part according to the modification in a simplified manner similarly to FIG. 13(a).
**[****FIG.14]** FIG. 14 is a view for describing water discharge holes and a cut-out part according to a second embodiment, in which FIG. 14(a) is a schematic view presented in a simplified manner similarly to FIG. 13(a), FIG. 14(b) is a view in which the water discharge holes 76₁, 76₂ in FIG. 14(a) are extracted, FIG. 14(c) is a cross-sectional view taken along the line U-U, and FIG. 14(d) is a cross-sectional view taken along the line V-V.

### [DETAILED DESCRIPTION OF THE EMBODIMENTS]

### <First Embodiment>

Hereinafter, a first embodiment of the present invention will be described with reference to the drawings. In this description, a case in which a connector unit is used as an equipment unit as an example will be described. However, the present invention is not particularly limited in type to a connector unit as long as it is an equipment unit comprising a metal component on a side of a non-waterproof region which will be described later, and may be another equipment unit. Note that in the description below, constitutive parts having the same function have the same number allotted, and repeated description will be omitted.

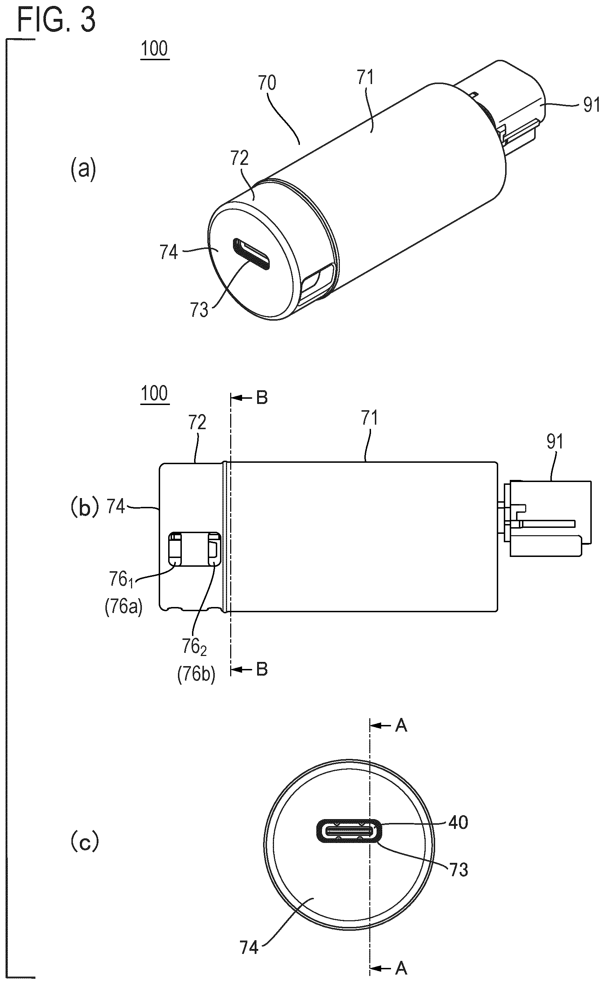

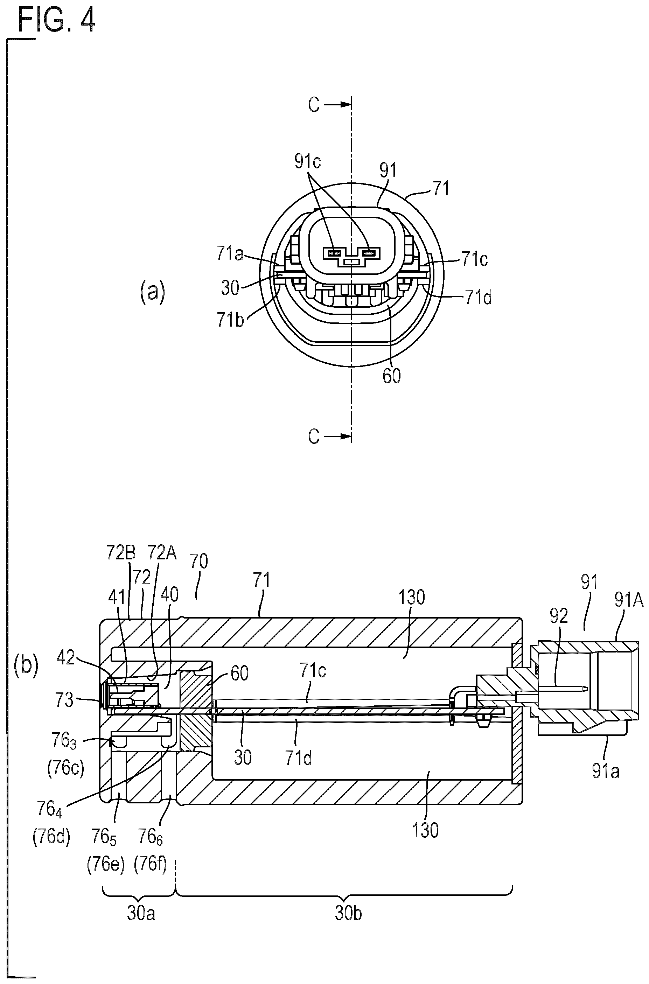

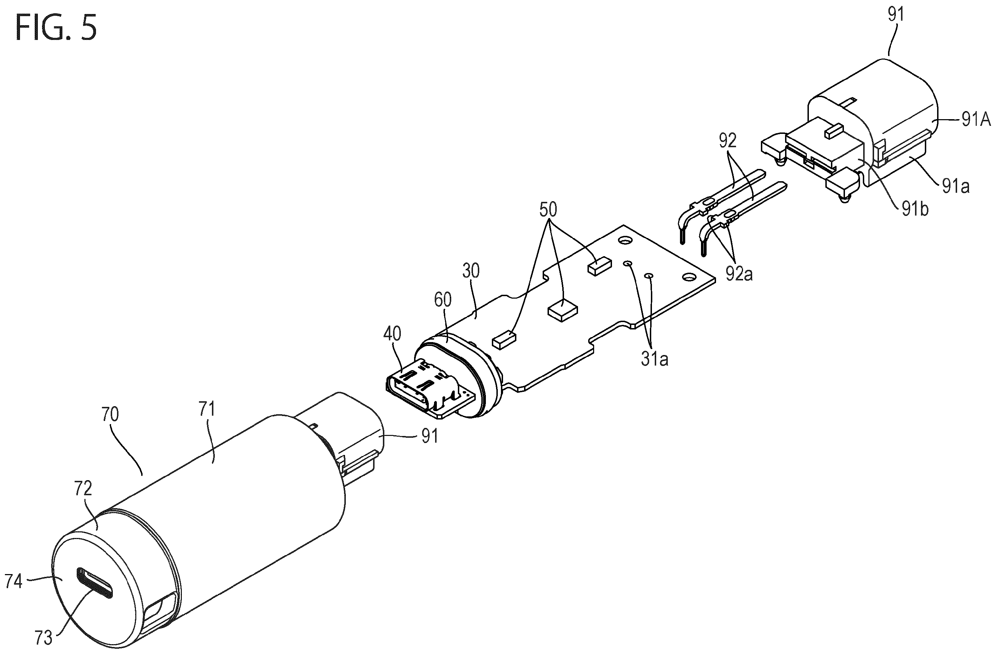

FIG. 3(a) is a perspective view showing an embodiment of a connector unit as an example of an equipment unit in the present embodiment, FIG. 3(b) is a side view thereof, and FIG. 3(c) is a front view thereof. FIG. 4(a) is a rear view of the connector unit shown in FIG. 3(a), and FIG. 4(b) is a cross-sectional view taken along the line C-C in FIG. 4(a). In FIG. 4(a), a potting resin 130 which will be described later is not shown, and in FIG. 4(b), electronic components 50 are not shown. FIG. 5 is an exploded perspective view of the connector unit shown in FIG. 3(a).

A connector unit 100 in the present embodiment comprises and is composed of a printed wiring board 30, an interface connector 40, the electronic components 50, a waterproof sealing member 60, a case 70, and a back face connector 91 as main elements as shown in FIG. 5.

### (Printed Wiring Board 30)

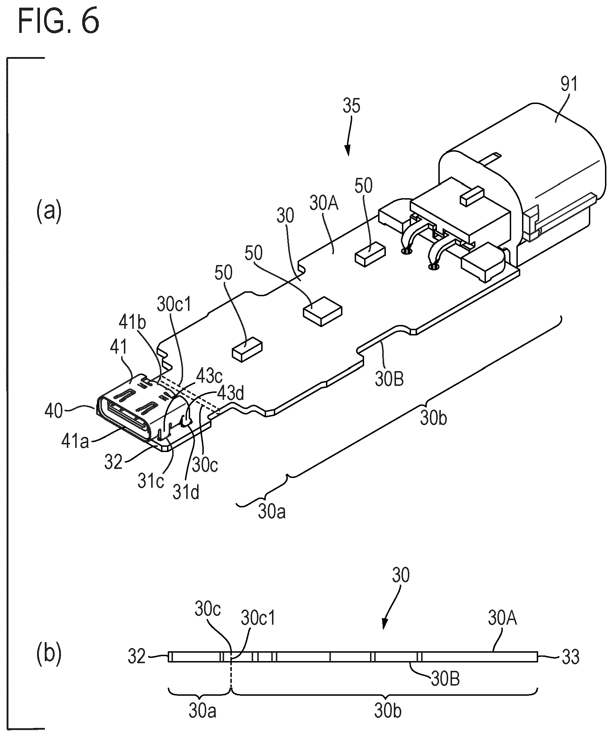

The printed wiring board 30 is a wiring board formed of a single layer or multiple layers mainly made of glass epoxy resin, for example. FIG. 6(a) is a perspective view showing a printed circuit board 35 in the connector unit shown in FIG. 3(a), and FIG. 6(b) is a side view of the printed wiring board 30 shown in FIG. 6(a).

The printed wiring board 30 in the present embodiment has an end part 32 having a flat plate shape formed of an upper face 30A having a substantially rectangular shape and a lower face 30B opposed to the upper face 30A and having an end face falling on one end in a length direction, and an end part 33 having an end face opposite to the end part 32, as shown in FIG. 6. The printed wiring board 30 has a first region 30a extending in a direction starting from the end part 32 toward the end part 33 and a second region 30b adjacent to this first region 30a and extending to the end part 33. When a plane at a border between the first region 30a and the second region 30b is defined as a boundary 30c, the first region 30a is a region from the end part 32 to the boundary 30c in the printed wiring board 30, and the second region 30b is a region from the boundary 30c to the end part 33 in the printed wiring board 30.

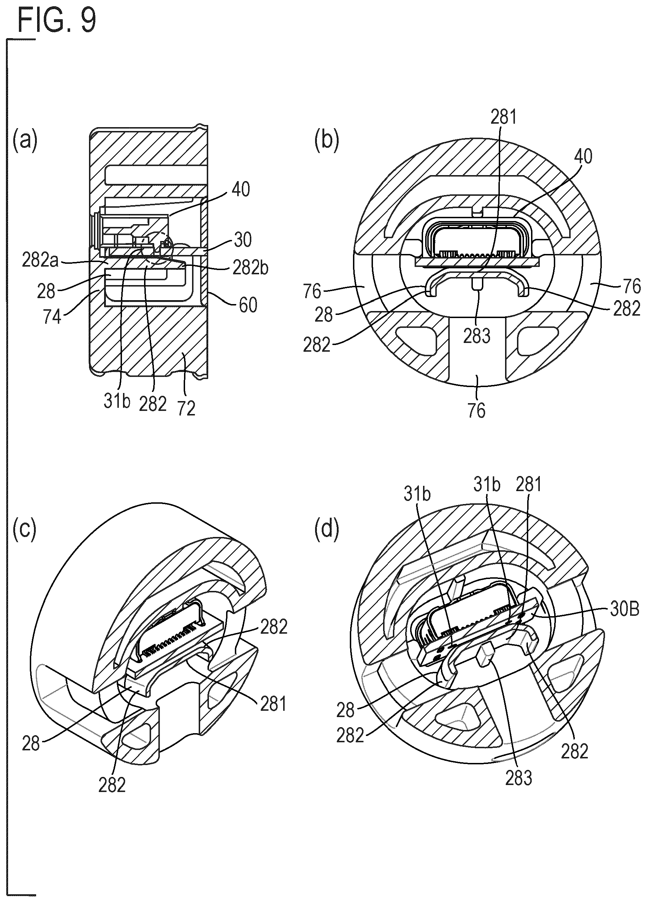

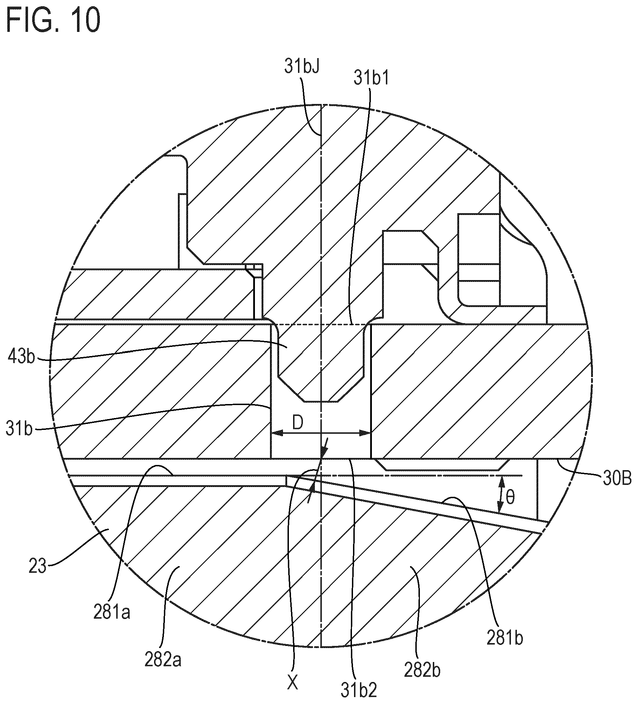

The interface connector 40, the electronic components 50, and the back face connector 91 are mounted on the upper face 30A of the printed wiring board 30. In the present embodiment, the printed wiring board 30 on which the interface connector 40, the electronic components 50, and the back face connector 91 are mounted shall be referred to as the "printed circuit board 35." The printed circuit board 35 is stored in the case 70 as shown in FIG. 4. Note that the printed wiring board 30 has two through-holes 31b (see FIG. 9). The through-hole 31b has a circular hole, and has two end parts, an end part 31b1 on the upper face 30A side and an end part 31b2 on the lower face 30B side (see FIG. 10).

### (Interface Connector 40)

On the upper face 30A of the printed wiring board 30, the interface connector 40 to be connected to a connector of a smartphone or the like, for example, is mounted on the end part 32 side of the first region 30a. The interface connector 40 is a kind of electronic component. As shown in FIG. 4 to FIG. 6, the interface connector 40 has a terminal 42 covered by a shell 41 formed of a metal non-watertight structure, and is located to face the outside of the case 70 through an opening 73 provided in a front face plate part 74 of the case 70. The shell 41 has a first end part 41a and a second end part 41b. The interface connector 40 includes two protrusions 43b (see the single protrusion 43b shown in FIG. 10) on the end part 41b side on the bottom face, and includes protrusions 43c and 43d (FIG. 6(a)) sequentially from the end part 41a side on both lateral surfaces of the shell 41. The protrusion 43b is inserted in the through-hole 31b (FIG. 10) provided in the printed wiring board 30. Similarly, the protrusions 43c and 43d are inserted in through-holes 31c and 31d, respectively. When the protrusions 43b, 43c, and 43d are inserted in the through-holes 31b, 31c, and 31d, the interface connector 40 is positioned on the printed wiring board 30. The through-holes 31b, 31c, and 31d are holes penetrating from the upper face 30A to the lower face 30B of the printed wiring board 30, and are formed as non-plated-through-holes here. The interface connector 40 in the present embodiment is a USB Type-C connector. However, the interface connector 40 is not particularly limited in type as long as it is an interface connector having a non-watertight structure. For example, another interface connector such as a USB Type-A connector or an HDMI (registered trademark) connector may be used. Even if the interface connector 40 receives water through the opening 73, received water will not be retained in the interface connector 40 as long as the amount of received water is small, and will be discharged to the outside of the interface connector 40 since the interface connector 40 has a non-watertight structure.

### (Electronic Components 50)

On the upper face 30A of the printed wiring board 30, the electronic components 50 which are surface-mounted components such as an IC chip and a capacitor, for example, are mounted on the second region 30b side. As the electronic components 50 in the present embodiment, a plurality of the electronic components 50 are mounted as shown in FIG. 6. The electronic components 50 in the present embodiment are electronic components of a type different from the interface connector 40 and the back face connector 91 which will be described later. However, the number of the electronic components 50 on the printed wiring board 30 is not limited to a plural number. In addition, in the present embodiment, the first region 30a side in the case 70 shall be a non-waterproof region, and the second region 30b side shall be a waterproof region, as will be described later. Therefore, an electronic component for which a countermeasure for waterproofness more effective than for the interface connector 40 is required may be included in the electronic components 50 in the present embodiment. Note that in a case in which the connector unit 100 of the present embodiment can be achieved without the electronic components 50, the electronic components 50 may not necessarily be mounted.

### (Waterproof Sealing Member 60)

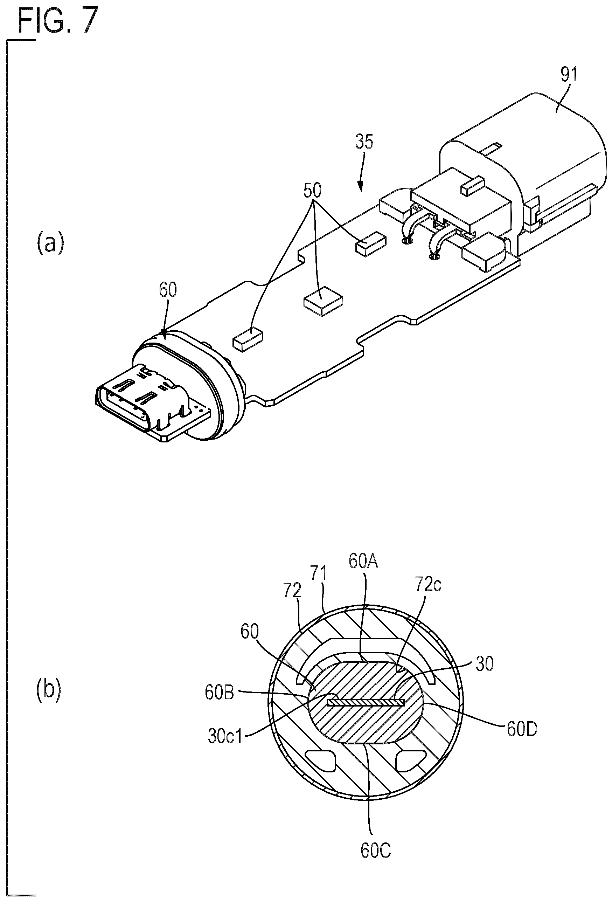

On the printed wiring board 30, the waterproof sealing member 60 made of a hot melt material is formed on an outer circumference 30c1 of the boundary 30c. FIG. 7(a) is a perspective view of the printed circuit board 35 with which the waterproof sealing member 60 has been formed integrally. FIG. 7(b) is a cross-sectional view as seen from the interface connector 40 side in a case in which the connector unit 100 is cut along a plane including the boundary 30c.

The waterproof sealing member 60 is formed integrally with the printed wiring board 30 in close contact with the printed wiring board 30 while following and covering the outer circumference 30c1 of the boundary 30c on the printed wiring board 30 as shown in FIG. 7. The waterproof sealing member 60 formed on the printed wiring board 30 has pressing faces 60A, 60B, 60C, and 60D that press an inner face of a tubular part 72 in a case in which the waterproof sealing member 60 is inserted in the case 70 as shown in FIG. 7(b). The pressing face 60A and the pressing face 60B, the pressing face 60B and the pressing face 60C, the pressing face 60C and the pressing face 60D, and the pressing face 60D and the pressing face 60A are continuous, and configure a continuous face as a whole. The pressing faces 60A, 60B, 60C, and 60D are arranged to press an inner circumference 72c which is an inner circumference of the tubular part 72 of the case 70 and which is opposed to the outer circumference 30c1 to come into close contact with the inner face of the tubular part 72. When the waterproof sealing member 60 is configured as described above, the waterproof sealing member 60 separates the inside of the case 70 into the first region 30a side and the second region 30b side.

In addition, the second region 30b side in the case 70 in the present embodiment serves as a waterproof region. Specific examples of achieving the waterproof region include injection of the potting resin 130 and provision of the back face connector 91 as will be described later.

When the waterproof sealing member 60 is provided and when the second region 30b side in the case 70 serves as the waterproof region, a waterproof function is exerted on the second region 30b side against not only received water through the opening 73 of the case 70 but also received water from a rear end side of the case 70 (opposite side to the front face plate part 74 in the case 70). Therefore, in whichever orientation the connector unit 100 is attached to another type of equipment such as a vehicle on which the connector unit 100 is mounted, a situation will not arise in which the printed wiring board 30 and the electronic components 50 on the second region 30b side in the case 70 are affected by received water.

The waterproof sealing member 60 is formed so as to be integral with the printed wiring board 30 by insert molding, for example. However, the waterproof sealing member 60 is not necessarily limited to being formed as a single member, and may be configured as a plurality of non-annular members configured independently from the printed wiring board 30, for example.

### (Case 70)

The printed circuit board 35 with which the waterproof sealing member 60 has been formed integrally is stored in the case 70. The case 70 is a molded product formed of thermoplastic resin such as ABS, for example. As already described, the waterproof sealing member 60 separates the inside of the case 70 into the first region 30a side and the second region 30b side. In other words, when a method for achieving the waterproof region which will be described later is applied, the case 70 is divided into the non-waterproof region and the waterproof region inside the case 70 using the waterproof sealing member 60 as the border.

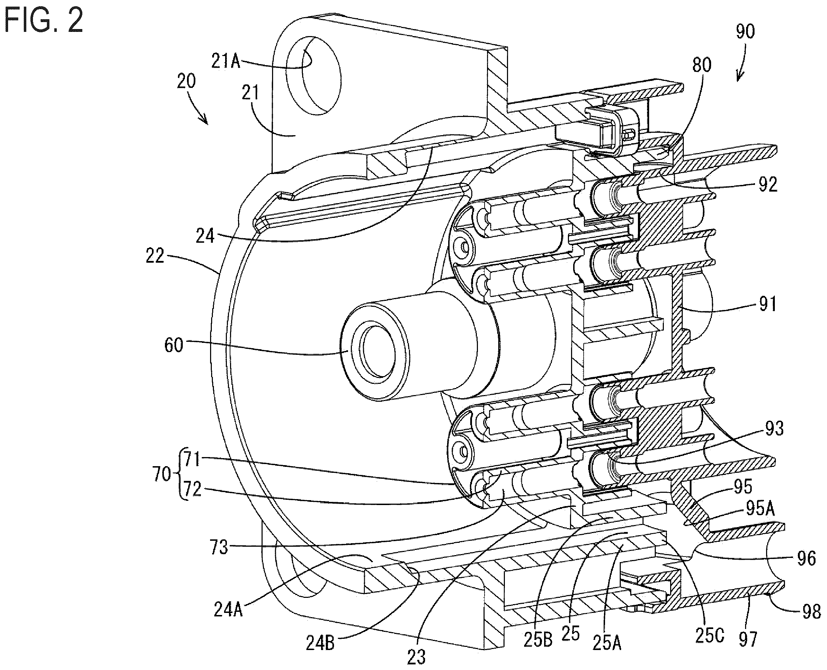

The case 70 has tubular parts 71 and 72 of a cylindrical shape and the front face plate part 74 located on a front end of the tubular part 72 as shown in FIG. 3 to FIG. 5. The tubular part 71 has a tubular shape that is larger to some extent than the tubular part 72. The opening 73 through which an opposing connector of the interface connector 40 can be inserted/removed is formed in the front face plate part 74 of the tubular part 72. Water discharge holes 76 are formed at six positions in total, two each on both lateral faces and a bottom face on the tubular part 72, in other words, the first region 30a side of the case 70. In FIGs. 3 and 2, subscript numbers are added to respective reference numerals in order to identify the respective water discharge holes. The opening 73 and the water discharge holes 76 all communicate with an inner space of the tubular part 72. Details of a structure of water discharge holes 76₁ to 76₄ will be described later.

The printed circuit board 35 with which the waterproof sealing member 60 has been formed integrally is pushed and inserted (press fitted) from the rear end side of the tubular part 71 (opposite side to the front face plate part 74 in the case 70) to be stored in the case 70. On an inner face of the tubular part 71, sliders 71a, 71b, 71c, and 71d are formed in lateral regions on both right and left sides as shown in FIG. 4(a). In the case in which the printed circuit board 35 with which the waterproof sealing member 60 has been formed integrally is pushed and inserted into the case 70, the printed circuit board 35 is pushed while one end part in a width direction of the printed wiring board 30 is inserted between the sliders 71a and 71b and while the other end part is inserted between the sliders 71c and 71d. Accordingly, the interface connector 40, the electronic components 50, the waterproof sealing member 60, and the back face connector 91 excluding a fitting part 91a, which are located on the printed wiring board 30, are stored at predetermined positions and predetermined heights in the case 70 together with the printed wiring board 30, as shown in FIG. 4(b).

The case 70 is separated by the waterproof sealing member 60 into the first region 30a side and the second region 30b side in the case 70. In other words, in the case in which the waterproof sealing member 60 is used as the waterproof sealing member, the pressing faces 60A, 60B, 60C, and 60D of the waterproof sealing member 60 press the inner face of the tubular part 72 as shown in FIG. 7(b). Accordingly, the waterproof sealing member 60 separates the inside of the case 70 into the first region 30a side and the second region 30b side.

### (Back Face Connector 91)

On the upper face 30A of the printed wiring board 30, the back face connector 91 to be connected to a harness connector (not shown) is mounted on the end part 33 side of the second region 30b. The back face connector 91 is a kind of electronic component. The back face connector 91 is composed of a housing 91A and terminals 92 as shown in FIG. 5. The housing 91A is tubular and formed of the fitting part 91a to be fitted with the harness connector described above and a base part 91b that covers a base end of the fitting part 91a. Two terminal press-fit holes 91c are formed in the base part 91b as shown in FIG. 4(a). The back face connector 91 in the present embodiment has the two terminals 92. The terminal 92 has a shape bent into an L-shape, and a pair of projections 92a protruding to both sides in the width direction are formed on one edge of the L-shape. As shown in FIG. 4 and FIG. 5, the terminal 92 is attached to the housing 91A with the one edge of the L-shape press fitted into the terminal press-fit hole 91c. The press-fitted one edge of the terminal 92 is in a state exposed inside the fitting part 91a so as to be connectable to the harness connector described above. On the other hand, the other edge of the L-shape of the terminal 92 is inserted in and solder-connected to a plated-through-hole 31a provided on the end part 33 side of the printed wiring board 30.

### (Specific Example 1 for Achieving Waterproof Region: Potting Resin 130)

After the waterproof sealing member 60 and the printed circuit board 35 are stored in the case 70, the potting resin 130 is injected to the second region 30b side in the case 70. Examples of the material for the potting resin 130 include, but are not limited to, urethane resin, epoxy resin, and silicon resin. The injected potting resin 130 is shown using the reference numeral in FIG. 4(b), but is shown without oblique lines or the like used or without being patterned so as to be identified from the tubular part 71 and the printed wiring board 30. Injection of the potting resin 130 is performed until the second region 30b side in the case 70 is filled with the potting resin 130 as shown in FIG. 4(b). When the second region 30b side is filled with this potting resin 130, the first region 30a side in the case 70 can serve as the non-waterproof region, and the second region 30b side can serve as the waterproof region.

### (Specific Example 2 for Achieving Waterproof Region: Back Face Cover 80)

A configuration may be adopted in which the second region 30b side in the case 70 is in a hollow state without injection of the potting resin 130 and in which the tubular part 71 is provided with a back face cover 80 instead to obtain waterproofness.

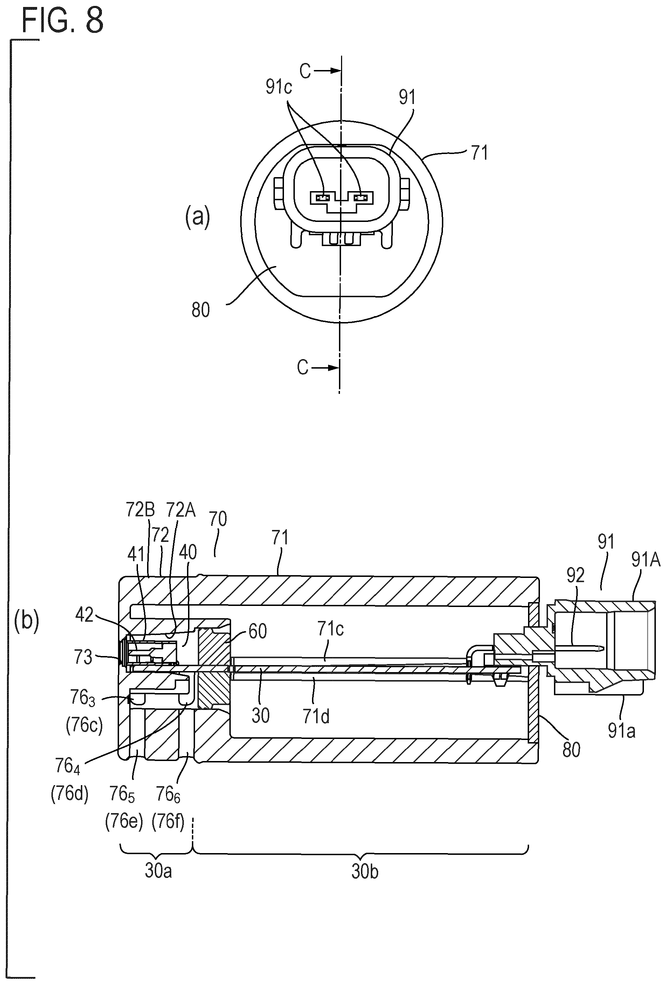

FIG. 8(a) is a rear view showing an embodiment of the connector unit in a case of having the back face cover 80, and FIG. 8(b) is a cross-sectional view taken along the line C-C in FIG. 8(a). In FIG. 8(b), the electronic components 50 are not shown. The connector unit 100 shown in FIG. 8, the second region 30b side in the case 70 is not filled with the potting resin 130 different from FIG. 4. Instead, a back end of the tubular part 71 of the case 70, in other words, an end on the second region 30b side in the case 70, is covered by the back face cover 80. The back face cover 80 has a circular flat plate of the same shape as the inner diameter of the tubular part 71. An abutting portion between the back face cover 80 and the case 70, in other words, an inner circumferential face of the back end of the tubular part 71 and an outer circumferential face of the back face cover 80, are bonded firmly with an adhesive or the like. When the back end of the tubular part 71 is covered by the back face cover 80, the waterproof function is exerted on the second region 30b side in the case 70.

In the case in which the back face cover 80 is provided, the back face cover 80 may be formed so as to be integral between the fitting part 91a and the base part 91b (FIG. 5). Accordingly, the base part 91b forms part of the back face cover 80, and the fitting part 91a protrudes backward from the back face cover 80. On the other hand, the back face cover 80 may be formed independently from the back face connector 91. For example, the back face cover 80 may have a structure of holding the back face connector 91. The back face cover 80 is considered to be formed of, but not limited to, a member of the same quality as the waterproof sealing member 60.

Also in the case in which the second region 30b side in the case 70 serves as the waterproof region, a configuration may be adopted in which the second region 30b side in the case 70 is filled with the potting resin 130 in order to increase the waterproof function by providing the back face cover 80. Note that in the case in which the potting resin 130 is not injected, moistureproof coating may be applied to the printed wiring board 30 in terms of water resistance even in the case in which the back face cover 80 is provided. As a coating agent, a room-temperature fluorine coating agent can be used, for example, and a urethane, acrylic, silicon, or another coating agent containing resin as a membrane element can also be used.

The back face cover 80 can exert the waterproof function on the second region 30b side in the case 70 similarly to the potting resin 130, and can additionally achieve the waterproof function more inexpensively than the potting resin 130.

### (Water-Guiding Member 28)

A water-guiding member 28 is formed in the tubular part 72. FIG. 9 is a view for describing the water-guiding member 28, in which FIG. 9(a) is a view displaying a region from the front face plate part 74 to the line B-B in FIG. 3(b) in the cross-sectional view taken along the line A-A in FIG. 3(c), FIG. 9(b) is a cross-sectional view taken along the line B-B in FIG. 3(b), FIG. 9(c) is a perspective view of FIG. 9(b) as seen from a left upper direction, and FIG. 9(d) is a perspective view of FIG. 9(b) as seen from a left lower direction. FIG. 10 is an enlarged view in a region indicated by a dash-dotted line in FIG. 9(a).

The water-guiding member 28 is formed on the lower face 30B side of the printed wiring board 30 below the interface connector 40 to protrude starting from the inner face of the front face plate part 74 to the waterproof sealing member 60 side. The water-guiding member 28 is composed of a base part 281, two leg parts 282, and a reinforcing part 283. The base part 281 has a flat plate shape that protrudes starting from the inner face of the front face plate part 74 to the waterproof sealing member 60 side to present a quadrangular prism having a rectangular bottom face.

Starting from the inner face of the front face plate part 74, the base part 281 is formed to have a constant plate thickness up to a region having a face 281a and to become thinner toward the waterproof sealing member 60 side in a region having a face 281b, as shown in FIG. 10. In other words, the face 281b is inclined from the face 281a by an angle θ in a direction away from the lower face 30B. The two leg parts 282 are provided respectively to extend in a curved shape from both end parts in the longitudinal direction of the base part 281. The base part 281 and the two leg parts 282 are continuous and form a C-shape as a whole. The base part 281 is at least partially arranged at a position opposed to each of the through-holes 31b. The leg parts 282 have a shape that protrudes starting from the inner face of the front face plate part 74 to the waterproof sealing member 60 side by the same length as the base part 281. The leg part 282 is formed to have a constant plate thickness to a predetermined region corresponding to the face 281a and to be thinner toward the waterproof sealing member 60 side in a region corresponding to the face 281b similarly to the base part 281. The reinforcing part 283 extends starting from the inner face of the front face plate part 74 to the waterproof sealing member 60 side so as to reinforce the base part 281 from a central position in the longitudinal direction of the base part 281. An extending length is formed to be slightly shorter than the base part 281.

The water-guiding member 28 has an inclined face (the face 281b) having a predetermined angle (90°-θ) with respect to a penetrating direction of the through-holes 31b, and is arranged such that a shortest distance (a distance X in FIG. 10) to the center of gravity of the shape of the end part 31b2 is a distance shorter than the radius of a largest circle that can be inserted into the shape of the end part 31b2, as shown in FIG. 10. In other words, in the example of FIG. 10, the water-guiding member 28 is provided at such a position that a relationship in which X < (D/2) holds is kept. Therefore, when received water having received protrudes downward from the end part 31b2, the received water comes into contact with the water-guiding member 28. In this case, the base part 281 having the inclined face and the leg parts 282 serve as a flow channel, and water supposed to be retained in the through-hole 31b flows downward. Therefore, the water-guiding member 28 discharges water entered into the through-hole 31b of the printed wiring board 30 to the outside of the printed wiring board 30. In addition, the thinned portion of the base part 281, the curved portions of the leg parts 282, and the thinned portions of the leg parts 282 guide the received water in directions of the respective portions.

The water-guiding member 28 configures a C-shape by the base part 281 and the leg parts 282, and has the reinforcing part 283 that reinforces the base part 281. The water-guiding member 28 is provided in contact with the inner face of the front face plate part 74. Therefore, even in a case in which a force is applied to the front face plate part 74 while an operation of inserting/removing the opposing connector of the interface connector 40 is being performed through the opening 73, deformation and breakage of the front face plate part 74 are reduced.

### (Water Discharge Hole 76, Cut-Out Parts 761)

The six water discharge holes 76 are formed in the tubular part 72. In a right lateral face of the tubular part 72 as seen from the front face plate part 74 side (FIG. 3(c)) (hereinafter, also referred to as "the right lateral face of the tubular part 72"), the water discharge hole 76₁ and the water discharge hole 76₂ are formed as a set of water discharge holes separated from one another by a predetermined distance in order from the front face plate part 74 side. In a left lateral face of the tubular part 72 as seen from the front face plate part 74 side (hereinafter, also referred to as "the left lateral face of the tubular part 72), the water discharge hole 76₃ and the water discharge hole 76₄ are formed as a set of water discharge holes separated from one another by a predetermined distance in order from the front face plate part 74 side. In the bottom face of the tubular part 72 as seen from the front face plate part 74 side, the water discharge hole 76₅ and the water discharge hole 76₆ are formed as a set of water discharge holes separated from one another by a predetermined distance in order from the front face plate part 74 side. Each of the water discharge holes 76₁ to 76₆ is formed to penetrate from a face 72A which is the inner face of the tubular part 72 to a face 72B which is an outer face. Hole shapes of the water discharge holes 76 which are through-holes have substantially corner-rounded quadrilateral hole shapes 76a, 76b, 76c, 76d, 76e, and 76f in order of the water discharge holes 76₁ to 76₆.

As will be described later, cut-out parts 761 are provided respectively between the water discharge hole 76₁ and the water discharge hole 76₂ and between the water discharge hole 76₃ and the water discharge hole 76₄. In the present embodiment, the water discharge hole 76₁ to 76₄ and the two cut-out parts 761 are formed in a bilaterally symmetric structure with the C-C cross-section shown in FIG. 4(a) serving as a reference plane. Hereinafter, the water discharge holes 76₁, 76₂ and the cut-out parts 761 provided between the water discharge holes 76₁ and 76₂ will be described. Description of the cut-out parts 761 provided between the water discharge holes 76₃ and 76₄ and between the water discharge holes 76₃ and 76₄, as well as the water discharge holes 76₅ and 76₆ not having the cut-out part 761 is omitted.

FIG. 11 is a view for describing the water discharge holes 76₁, 76₂ and the cut-out part 761 according to the first embodiment. FIG. 11(a) is a side view of the connector unit 100, FIG. 11(b) is a cross-sectional view taken along the line Y-Y in FIG. 11(a), FIG. 11(c) is an enlarged view corresponding to a region enclosed by a dash-dotted line in FIG. 11(b) in the cross-sectional view taken along the line X-X in FIG. 11(a), FIG. 11(d) is an enlarged view corresponding to a region enclosed by a dash-dotted line portion in FIG. 11(b) in the cross-sectional view taken along the line Z-Z in FIG. 11(a), FIG. 11(e) is a cross-sectional view taken along the line W-W in FIG. 11(a), and FIG. 11(f) is an enlarged view of a region enclosed by a dash-dotted line portion in FIG. 11(e). For the sake of description, the water-guiding member 28 and the printed wiring board 30 which are visible through the water discharge hole 76₁ and the water discharge hole 76₂ are not shown in FIG. 11(a).

The cut-out part 761 having a length L2 (FIG. 11(f)) is provided between the water discharge hole 76₁ and the water discharge hole 76₂ which are a set of water discharge holes, as shown in FIG. 11. The cut-out part 761 has a hole shape that enlarges the hole shapes of the water discharge holes while being in contact with part of the circumferences of the hole shapes from a position along the penetrating direction to reach the outer face of the case in the water discharge holes. In other words, the cut-out part 761 is formed such that the tubular part 72 is cut out in the water discharge hole 76₁ and the water discharge hole 76₂ by a length (the length L2) starting from a position that is away from the face 72A by a length L1, which falls on a position between the inner face (the face 72A) of the tubular part 72 and the outer face (the face 72B) in the penetrating direction, to reach the face 72B.

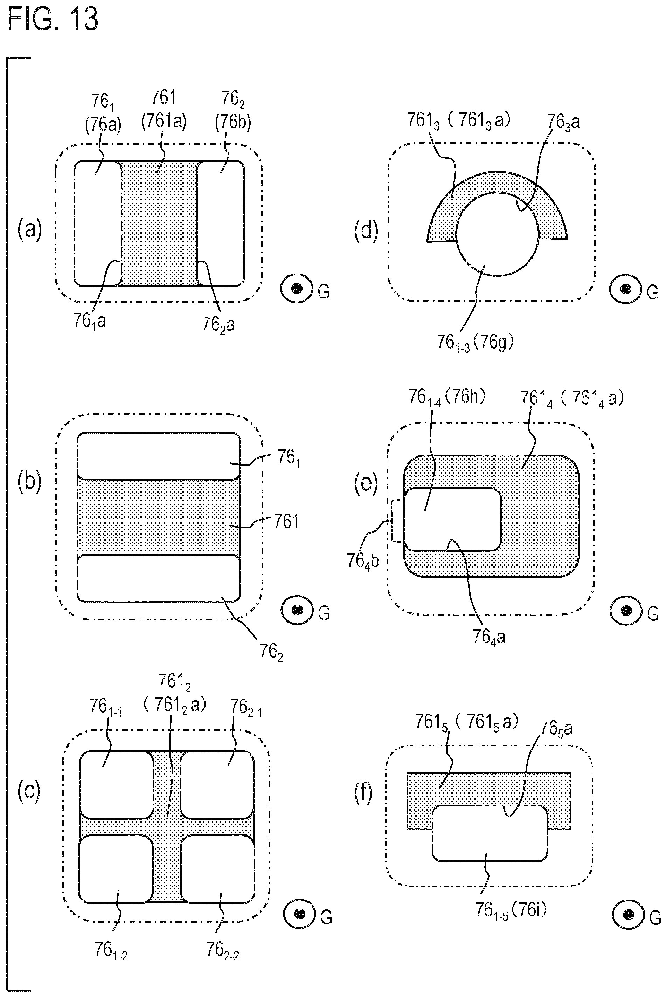

In addition, the cut-out part 761 has a substantially rectangular hole shape 761a that enlarges the hole shape 76a and the hole shape 76b while being in contact with end parts 76₁a and 76₂a (see FIG. 13(a)), which are part of the circumferences of the holes at positions away from the face 72A by the length L1 starting from the face 72A in the water discharge holes (76₁, 76₂). In other words, the cut-out part 761 is formed such that the tubular part 72 is cut out by the length L2 in the penetrating direction (the direction penetrating from the face 72A to the face 72B) starting from the end parts 76₁a and 76₂a while having the hole shape 761a. Accordingly, the cut-out part 761 forms a substantially cuboid space (opening) having the hole shape 761a.

When the cut-out part 761 is provided, the water discharge hole 76₁ and the water discharge hole 76₂ are changed in hole size and shape at the position of the length L1 serving as the border (in other words, starting from the end parts 76₁a and 76₂a). The water discharge hole 76₁ and the water discharge hole 76₂ respectively have the shape and size of the hole shapes 76a and 76b to the end parts 76₁a and 76₂a at the distance of the length L1 from the face 72A. The hole shape of the water discharge hole 76₁ and the water discharge hole 76₂ becomes a shape in which three hole shapes of the hole shape 76a, the hole shape 761a, and the hole shape 76b are coupled in the portion having the length L2 from the end parts 76₁a, 76₂a to reach the face 72B. In other words, the water discharge hole 76₁ and the water discharge hole 76₂ have a discontinuous hole shape from the positions (the end parts 76₁a, 76₂a) at the length L1, which are positions along the penetrating direction, and are changed in shape and size from the two hole shapes having the hole shapes 76a and 76b to a single hole shape having a size of the hole shape 76a + the hole shape 761a + the hole shape 76b.

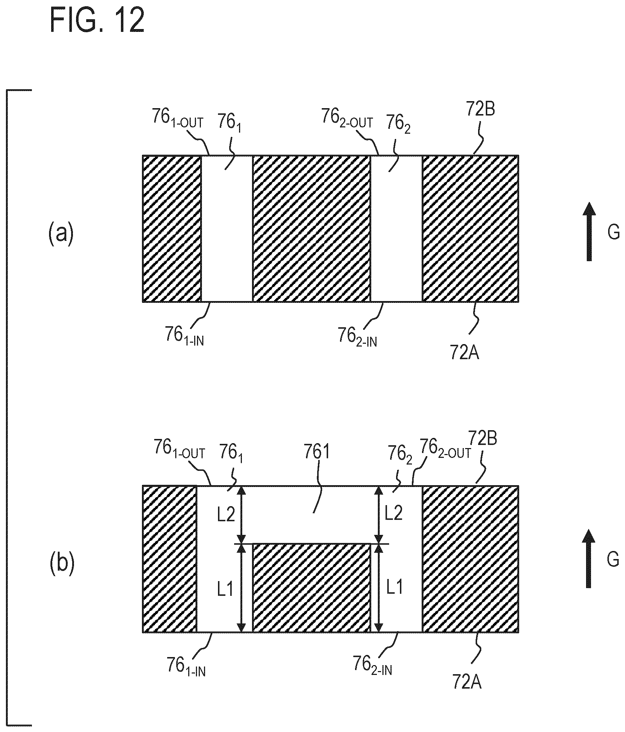

FIG. 12 is a schematic view corresponding to FIG. 11(f) showing an example of an influence on water discharge caused by providing the cut-out part 761, in which FIG. 12(a) is a case in which the cut-out part 761 is not provided, and FIG. 12(b) is a case in which the cut-out part 761 is provided. The connector unit 100 is assumed to be attached to and used in a motorcycle, another vehicle, or the like, for example, and a posture in a usage state is not necessarily maintained in the state shown in FIG. 3. That is, the connector unit 100 may be used in various postures according to a user's usage pattern. Therefore, the following description will be given based on a posture in which the penetrating direction of the water discharge holes 76 and a gravity direction match, which is considered to promote water discharge most. A gravity direction (G) in FIG. 12 shall be a perpendicular upward direction when FIG. 12 is seen from the front. In addition, openings of the water discharge holes 76₁ and 76₂ on the face 72A side shall be water discharge holes 76_{1-IN} and 76_{2-IN}, and openings on the face 72B side shall be water discharge holes 76_{1-OUT} and 76_{2-OUT}. Received water having been received at the opening 73 propagates on the printed wiring board 30 through the interface connector 40 to reach the face 72A in the tubular part 72, or directly reaches the face 72A from the interface connector 40. Part of the received water having reached the face 72A enters the water discharge holes 76_{1-IN} and 76_{2-IN} and flows to the water discharge holes 76_{1-OUT} and 76_{2-OUT}.

In the case in which the cut-out part 761 is not provided (FIG. 12(a)), received water flowed to the water discharge holes 76_{1-OUT} and 76_{2-OUT} may cause the trapping phenomenon in the neighborhood of the water discharge holes 76_{1-OUT} and 76_{2-OUT} which are outlets in the water discharge holes. The connector unit 100 is formed with certain restrictions imposed on the shape and size of the water discharge holes 76 in order to prevent foreign matter contamination in the tubular part 72. As a factor, the trapping phenomenon is likely to occur in a case in which a sufficient size of the hole shape of the water discharge holes 76 cannot be ensured, so that received water does not become a large liquid droplet that can drop down.

In the case in which the cut-out part 761 is provided (FIG. 12(b)), the hole shape is enlarged significantly in size of the hole shape from the hole shape 76a or the hole shape 76b to the hole shape 76a + the hole shape 761a + the hole shape 76b at the position of the length L1, in other words, at the end part 76₁a or 76₂a (see FIG. 13(a)) serving as the border. This significant change is limited to some directions of the end parts 76₁a and 76₂a (see FIG. 13(a)) rather than to all directions on the circumferences of the water discharge holes. In other words, the water discharge holes 76₁ and 76₂ are cut out in predetermined ranges on the circumferences of the hole shape 76a and the hole shape 76b. Received water entered into the water discharge holes 76_{1-IN} and 76_{2-IN} produces the trapping phenomenon at the end parts 76₁a and 76₂a (in other words, the cut-out circumferential regions) while the direction of flow from the face 72A to the face 72B is maintained. On the other hand, the water discharge holes as the water discharge holes 76₁ and 76₂ continue to reach the face 72B in circumferential regions on the not cut-out side, and thus, received water is going to maintain the flow in the penetrating direction as it is. In addition to this, there is also a subsequent flow of received water, which accelerates the situation described above. Accordingly, an orientation of a leading end surface of received water in the neighborhood of the end parts 76₁a and 76₂a will be inclined toward the cut-out regions by a certain angle from the penetrating direction. In other words, a state arises in which received water stuck on the circumference on the not cut-out side becomes closer to the face 72B than received water stuck on the circumference on the cut-out side is. As a result, a state is likely to arise in which the orientation of the leading end surface of received water in the neighborhood of the end parts 76₁a and 76₂a is directed to a direction inclined obliquely from the penetrating direction.

Therefore, in the water discharge holes 76₁ and 76₂ provided with the cut-out part 761, the diameter of a liquid droplet retained in the neighborhood of the end parts 76₁a and 76₂a is likely to be a liquid droplet having a diameter larger than in a case in which the cut-out part 761 is absent. If a liquid droplet having a diameter larger than in the case in which the cut-out part 761 is absent occurs, the liquid droplet has a weight larger than in FIG. 12(a), becomes weaker in surface tension, and is easier to drop. Therefore, the trapping phenomenon can be avoided by providing the cut-out part 761. In addition, depending on conditions such as the quantity and flow speed of received water entered into the water discharge holes 76₁ and 76₂, a liquid droplet of received water through the water discharge hole 76₁ and a liquid droplet of received water through the water discharge hole 76₂ abut on each other in the cut-out part 761 to become a larger liquid droplet. In these cases, the risk of foreign matter contamination will not be increased since the water discharge holes 76₁ and 76₂ have the hole shapes on the face 72A side still maintained at the size of the original hole shapes 76a and 76b although the hole shape on the face 72B side increases because of provision of the cut-out part 761.

By providing the water discharge hole 76 with the cut-out part 761 in this manner, a liquid droplet resulting from retained received water can be made larger in diameter and easier to drop than in the case in which the cut-out part is not provided. Thus, water entered into the water discharge holes in the equipment can be discharged proactively without increasing the risk of foreign matter contamination in the equipment.

### <Modification of First Embodiment>

FIG. 13 is a view for describing water discharge holes and a cut-out part according to a modification of the first embodiment, in which FIG. 13(a) is a schematic view presenting the vicinity of the water discharge hole 76₁ and the water discharge hole 76₂ in FIG. 11(a) in a simplified manner, and FIG. 13(b) to FIG. 13(f) are schematic views presenting the water discharge holes and the cut-out part according to the modification in a simplified manner similarly to FIG. 13(a). FIG. 13 shows the region of the cut-out part using a dotted pattern in order to identify the water discharge holes and the cut-out part. The gravity direction (G) in FIG. 13 shall be a perpendicular near-side direction when FIG. 13 is seen from the front.

A direction in which the water discharge holes are arrayed in the tubular part 72 described above may be a vertical direction. As shown in FIG. 13(b), for example, the water discharge hole 76₁ may be provided in a horizontally-long direction in the right lateral face of the tubular part 72, and therebelow (in other words, in the vertical direction) the water discharge hole 76₂ away from the water discharge hole 76₁ by a predetermined distance may be provided in the horizontally-long direction, and the cut-out part 761 may be formed therebetween. The absence of limitations on the direction in which the water discharge holes are arrayed results in an advantage of greater flexibility in design.

The tubular part 72 may be provided with a plurality of sets of water discharge holes. As shown in FIG. 13(c), for example, water discharge holes (the water discharge holes 76₁₋₁, 76₂₋₁ and the water discharge holes 76₁₋₂, 76₂₋₂) provided while being separated from one another by a predetermined distance may be provided in two sets, and moreover, the sets of the water discharge holes may be provided while being separated from one another by a predetermined distance. In this case, a cut-out part 761₂ having a substantially cross hole shape 761₂a is formed between the respective water discharge holes. In order to strengthen the countermeasure against foreign matter contamination, for example, there may be a case in which only water discharge holes having a hole shape smaller than the water discharge holes 76₁ and 76₂ described above can be provided. In this case, when a plurality of sets of the water discharge holes are provided as in FIG. 13(c) and when the number of the water discharge holes 76 and the size of the cut-out part 761 are adjusted as appropriate, the countermeasure against foreign matter contamination can be taken more strongly with a water discharge effect equivalent to FIG. 13(a) being exerted.

The cut-out part may be provided for each water discharge hole. Specifically, the cut-out part may be formed in a single water discharge hole to have a hole shape that enlarges the hole shape of the water discharge hole while being in contact with at least a half of the circumference of the hole shape from a position along the penetrating direction to reach the outer side of the case. In a case in which a water discharge hole 76₁₋₃ having a circular hole shape 76g is provided as shown in FIG. 13(d), for example, a cut-out part 761₃ is formed so as to have a hole shape 761₃a that enlarges the hole shape 76g while being in contact with an end part 76₃a falling on at least a half of the circumference of the water discharge hole 76₁₋₃. The cut-out part 761₃ is a cut-out part dedicated for the water discharge hole 76₁₋₃ and is not shared by another water discharge hole. Therefore, in FIG. 13(d), flexibility in direction and shape of cutting out the tubular part 72 is greater than in FIG. 13(a), whereby flexibility in design increases.

The cut-out part may be formed as shown in FIG. 13(e) in a case in which the size of the cut-out part can be ensured to be wider than in FIG. 13(d). FIG. 13(e) is another example in a case in which more than or equal to the half of the circumference of the water discharge hole 76₁₋₃ is ensured for the length of the end part 76₃a. As shown in FIG. 13(e), a cut-out part 761₄ is in contact with an end part 76₄a (three edges and four corners of a corner-rounded quadrangle) which is a large part of the circumference of a water discharge hole 76₁₋₄ having a corner-rounded quadrangular hole shape 76h, and is not in contact with an end part 76₄b. The cut-out part 761₄ has a hole shape 761₄a that enlarges the corner-rounded quadrangular hole shape 76h. In the case of FIG. 13(e), a large part of the water discharge hole 76₁₋₄ is included in the cut-out part 761₄, but a face of the water discharge hole 76₁₋₄ in the penetrating direction including the end part 76₄b configures a continuous face from the face 72A to reach the face 72B. Therefore, not only retention of received water in the cut-out part 761₄ but also the flow in the water discharge direction is maintained, whereby the drop-down effect is exerted.

In the case of having a corner-rounded quadrangular hole shape, the cut-out part may be formed so as to at least include and come into contact with one edge of the circumference of the water discharge hole 76 and corners at both ends of the one edge. As shown in FIG. 13(f), for example, a cut-out part 761₅ is in contact with an end part 76₅a including one edge in the longitudinal direction of a water discharge hole 76₁₋₅ having a corner-rounded quadrangular hole shape 76i and corners at both ends of the one edge. The cut-out part 761₅ has a hole shape 761₅a. In a case in which a hole shape of a size approximately equal to or larger than the hole shape 761₅a can be ensured for the cut-out part 761₅, the cut-out part 761₅ may be formed so as to be in contact with an end part including one edge in a shorter-side direction of the water discharge hole 76₁₋₅ and corners at both ends of the one edge. An advantage of greater flexibility in design than in FIG. 13(d) is obtained in that it is not restricted by the condition that the cut-out part should be in contact with at least the half of the circumference of the water discharge hole even though the hole shape is conditioned to be a corner-rounded quadrangle.

The cut-out parts described above according to the first embodiment and the modification thereof have a hole shape that enlarges the hole shape of the water discharge hole while being in contact with, in the water discharge hole, a predetermined range on the circumference of the hole shape of the water discharge hole from a position along the penetrating direction (the direction from the face 72A to the face 72B) to reach the outer side of the tubular part 72 that configures the case 70. In other words, the cut-out part cuts out, in the water discharge hole, a predetermined range on the circumference of the hole shape of the water discharge hole from a position along the penetrating direction to reach the outer side of the case 70. Accordingly, a liquid droplet resulting from retained received water can be made larger in diameter and easier to drop than in the case in which the cut-out part is not provided. Therefore, in either of the first embodiment and the modification thereof, water entered into the water discharge holes in the equipment can be discharged proactively without increasing the risk of foreign matter contamination in the equipment.

### <Second Embodiment>

A second embodiment has a configuration in which a protruding part 77 that protrudes to a still outer side from the outer face (the face 72B) of the tubular part 72 is provided on part of the circumference of a water discharge hole without providing a cut-out part, thereby obtaining effects similar to the first.

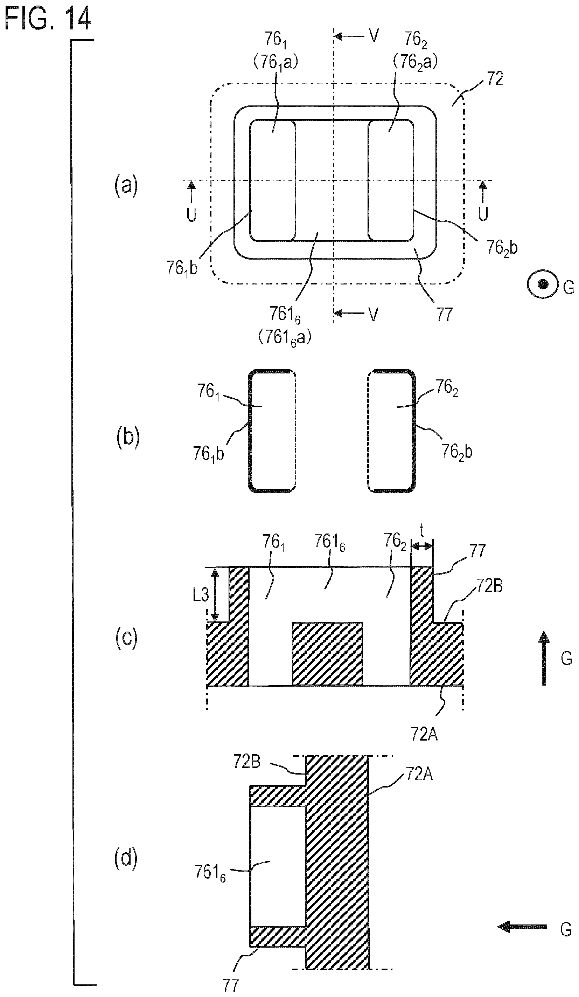

FIG. 14 is a view for describing water discharge holes and a cut-out part according to the second embodiment. FIG. 14(a) is a schematic view presented in a simplified manner similarly to FIG. 13(a), FIG. 14(b) is a view of the water discharge holes 76₁ and 76₂ extracted from FIG. 14(a), FIG. 14(c) is a cross-sectional view taken along the line U-U, and FIG. 14(d) is a cross-sectional view taken along the line V-V. The present embodiment has a set of the water discharge holes 76₁ and 76₂ similarly to the first embodiment.

The tubular part 72 in the second embodiment has the protruding part 77. The protruding part 77 is provided on the outer face (the face 72B) of the tubular part 72, surrounds the set of the water discharge holes 76₁, 76₂ while being in continuous contact with three edges and two corners (the end parts 76₁b, 76₂b) between the edges that configure part of the circumference of each of the water discharge holes 76₁, 76₂, and protrudes in the direction to the still outer side from the face 72B with a plate thickness t. A protruding length L3 is adjusted as appropriate with reference to the length of the length L2 (FIG. 12) described above. In FIG. 14(b), in order to explicitly show the ranges of the end parts 76₁b and 76₂b, the water discharge holes 76₁ and 76₂ are depicted by dotted lines, and the end parts 76₁b and 76₂b are depicted by bold lines.

When the protruding part 77 is provided, the water discharge holes 76₁ and 76₂ extend to a still outer side from the face 72B. Along with the extension of the water discharge holes 76₁ and 76₂, an opening 761₆ which is a space having a hole shape 761₆a is formed. In other words, two holes having the hole shape 76₁a and the hole shape 76₂a are formed from the face 72A to the face 72B, and a single hole shape (the hole shape 76₁a + the hole shape 761₆a + the hole shape 76₂a) is formed on the outer side from the face 72B. From another point of view, it is considered that the opening 761₆ is obtained by cutting out a predetermined range on the circumferences of the hole shape 76₁a and the hole shape 76₂a in the water discharge holes 76₁ and 76₂. Therefore, the opening 761₆ has a function equivalent to that of the cut-out part 761, whereby water entered into the water discharge holes in the equipment can be discharged proactively without increasing the risk of foreign matter contamination in the equipment.

### <Modification of Second Embodiment>

As described above, the opening 761₆ has a function equivalent to that of the cut-out part 761. Therefore, a protruding part in which a region corresponding to a cut-out part is caused to protrude to a still outer side from the face 72B may be provided in FIG. 13(a) to (c) instead of providing a cut-out part. In the case in which the water discharge hole 76₁ and the water discharge hole 76₂ shown in FIG. 13(b), for example, are provided, a region corresponding to the cut-out part 761 may be provided as a protruding part in a manner protruding to a still outer side from the face 72B instead of providing the cut-out part 761. Alternatively, in the case in which the water discharge holes 76₁₋₁, 76₂₋₁ and the water discharge holes 76₁₋₂, 76₂₋₂ shown in FIG. 13(c) are provided, a region corresponding to the cut-out part 761₂ may be provided as a protruding part in a manner protruding to a still outer side from the face 72B instead of providing the cut-out part 761₂.

A protruding part may be provided for each water discharge hole similar to the cut-out part 761. Therefore, a protruding part in which a region corresponding to a cut-out part is caused to protrude to a still outer side from the face 72B may be provided instead of providing the cut-out part in FIG. 13(d) to (f). In the case in which the water discharge hole 76₁₋₃ shown in FIG. 13(d), for example, is provided, a region ensured by a predetermined thickness (e.g., a thickness t) from the end part 76₃a may be provided as a protruding part in a manner protruding to a still outer side from the face 72B instead of providing the cut-out part 761₃. Alternatively, in the case in which the water discharge hole 76₁₋₄ shown in FIG. 13(e) is provided, a region ensured by a predetermined thickness (e.g., the thickness t) from the end part 76₄a may be provided as a protruding part in a manner protruding to a still outer side from the face 72B instead of providing the cut-out part 761₄. In the case in which the water discharge hole 76₁₋₅ shown in FIG. 13(f) is provided, a region ensured by a predetermined thickness (e.g., the thickness t) from the end part 76₅a may be provided as a protruding part in a manner protruding to a still outer side from the face 72B instead of providing the cut-out part 761₅.

The protruding parts according to the second embodiment and the modification thereof described above are provided on the outer face (the face 72B) of the tubular part 72 that configures the case 70 and protrude in the penetrating direction (the direction from the face 72A to the face 72B) from the tubular part 72 while being in contact with a predetermined range on the circumference of the water discharge holes. In either of the second embodiment and the modification thereof, water entered into the water discharge holes in the equipment can be discharged proactively without increasing the risk of foreign matter contamination in the equipment.

Although the first embodiment and the modification thereof and the second embodiment and the modification thereof have been described above, the hole shape of the water discharge holes 76 is not limited to the shapes described above, and may have another hole shape. For example, the hole shape of the water discharge holes 76₁, 76₂, 76₁₋₁, 76₂₋₁, 76₁₋₂, 76₂₋₂, and 76₁₋₄ is not limited to a corner-rounded quadrangle, and may be another hole shape such as a circle or an oval. The hole shape of the water discharge hole 76₁₋₃ is not limited to a circle, and may be another shape such as a corner-rounded quadrangle or an oval. The cut-out part 761 may be provided between the water discharge holes 76₅ and 76₆ formed in the bottom face of the tubular part 72. Besides, it is needless to say that the connector unit 100 described in the present embodiment can be changed as appropriate within a scope not departing from the spirit of the present invention.

### [DESCRIPTION OF REFERENCE NUMERALS]

28 water-guiding member
30 printed wiring board
30A upper face
30a first region
30B lower face
30b second region
30c boundary
30c1 outer circumference
31a plated-through-hole
31b to 31d through-hole
31b1, 31b2 end part
31bJ axis
32, 33 end part
35 printed circuit board
40 interface connector
41 shell
41a, 41b end part
42 terminal
43b to 43d protrusion
50 electronic component
60 waterproof sealing member
60A to 60D pressing face
70 case
71, 72 tubular part
71a to 71d slider
72c inner circumference
72A, 72B face
73 opening
74 front face plate part
76 water discharge hole
76₁a to 76₅a end part
76₁b, 76₂b end part
76a to 76i hole shape
761a hole shape
761₂a to 761₆a hole shape
761 cut-out part
761₂ to 761₅ cut-out part
761₆ opening
77 protruding part
80 back face cover
91 back face connector
91A housing
91a fitting part
91b base part
91c terminal press-fit hole
92 terminal
92a projection
100 connector unit
130 potting resin
281 base part
281a, 281b face
282 leg part
282a, 282b face
283 reinforcing part
D diameter
L1, L2 length
t thickness
X distance

## Claims

1. An equipment unit comprising:
a case, an inside of which is divided into a waterproof region and a non-waterproof region; and
a metal component mounted in the non-waterproof region of the case, wherein
the case includes
a water discharge hole provided on a side of the non-waterproof region and having a first hole shape penetrating from an inner side to an outer side of the case for discharging received water in the metal component, and
a cut-out part formed by cutting out a predetermined range on a circumference of the first hole shape from a position along a penetrating direction to reach the outer side of the case in the water discharge hole.

2. The equipment unit according to claim 1, wherein the predetermined range on the circumference of the first hole shape in the cut-out part is at least a half of the circumference of the first hole shape.

3. The equipment unit according to claim 1, wherein
the first hole shape in the water discharge hole is a corner-rounded quadrangle, and
the predetermined range on the circumference of the first hole shape in the cut-out part includes at least one edge of the hole shape which is the corner-rounded quadrangle and corners at both ends of the one edge.

4. An equipment unit comprising:
a case, an inside of which is divided into a waterproof region and a non-waterproof region; and
a metal component mounted in the non-waterproof region of the case, wherein
the case includes
a set of water discharge holes provided on a side of the non-waterproof region separated from one another by a predetermined distance and each having a first hole shape penetrating from an inner side to an outer side of the case for discharging received water in the metal component, and
a cut-out part provided between the set of water discharge holes and having a second hole shape that enlarges the first hole shape while being in contact with part of a circumference of each of the water discharge holes from a position along the penetrating direction of each of the water discharge holes to reach the outer side of the case.

5. An equipment unit comprising:
a case, an inside of which is divided into a waterproof region and a non-waterproof region; and
a metal component mounted in the non-waterproof region of the case, wherein
the case includes
a water discharge hole provided on a side of the non-waterproof region and having a first hole shape penetrating from an inner side to an outer side of the case for discharging received water in the metal component, and
a protruding part provided on an outer face of the case and protruding in a penetrating direction from the case while being in contact with a predetermined range on a circumference of the first hole shape.

6. The equipment unit according to claim 5, wherein the predetermined range on the circumference of the first hole shape in the protruding part is at least a half of the circumference of the first hole shape.

7. An equipment unit comprising:
a case, an inside of which is divided into a waterproof region and a non-waterproof region; and
a metal component mounted in the non-waterproof region of the case, wherein
the case includes
a set of water discharge holes provided on a side of the non-waterproof region separated from one another by a predetermined distance and each having a first hole shape penetrating from an inner side to an outer side of the case for discharging received water in the metal component, and
a protruding part provided between the set of water discharge holes on an outer face of the case and protruding in a penetrating direction from the case while being in continuous contact with part of a circumference of each of the water discharge holes.

8. The equipment unit according to claim 7, wherein the protruding part is provided on the outer face of the case, surrounds the set of water discharge holes while being in continuous contact with part of the circumference of each of the water discharge holes, and protrudes in the penetrating direction from the case.

9. The equipment unit according to any one of claims 1 to 2 or claims 4 to 8, wherein the hole shape of the water discharge hole is any of a circle, an oval, or a corner-rounded quadrangle.
